Europäisches Patentamt

European Patent Office

Office européen des brevets

(11) Veröffentlichungsnummer: **0 282 629 B1**

# EUROPÄISCHE PATENTSCHRIFT

(45) Veröffentlichungstag der Patentschrift: **11.11.92**

(51) Int. Cl.5: **H01L 27/10**, H01L 21/82

(21) Anmeldenummer: **87112417.8**

(22) Anmeldetag: **26.08.87**

(54) **Dreidimensionale 1-Transistorzellenanordung für dynamische Halbleiterspeicher mit Grabenkondensator und Verfahren zur Herstellung des Bitleitungskontaktes.**

(30) Priorität: **06.03.87 DE 3707241**

(43) Veröffentlichungstag der Anmeldung:
**21.09.88 Patentblatt 88/38**

(45) Bekanntmachung des Hinweises auf die Patenterteilung:
**11.11.92 Patentblatt 92/46**

(84) Benannte Vertragsstaaten:
**AT DE FR GB IT NL**

(56) Entgegenhaltungen:
**EP-A- 0 054 129**
**EP-A- 0 149 799**

**PATENT ABSTRACTS OF JAPAN, Band 10, Nr. 217 (E-423)[2273], 29. Juli 1986; & JP-A-61 54 661 (TOSHIBA CORP.) 18-03-1986**

**Idem**

(73) Patentinhaber: **SIEMENS AKTIENGESELL-SCHAFT**
**Wittelsbacherplatz 2**
**W-8000 München 2(DE)**

(72) Erfinder: **Küsters, Karl-Heinz, Dr.**
**Heinrich-Wieland-Strasse 71**
**W-8000 München 83(DE)**
Erfinder: **Müller, Wolfgang, Dr.**
**Th.-Heuss-Strasse 12**
**W-8011 Putzbrunn(DE)**
Erfinder: **Enders, Gerd, Dipl.-Ing.**
**Ottobrunner Strasse 96**
**W-8000 München 83(DE)**

EP 0 282 629 B1

**Beschreibung**

Die Erfindung betrifft eine dreidimensionale 1-Transistorzellenanordnung für dynamische Halbleiterspeicher, bei der der Kondensator für die zu speichernden Ladungen als Grabenkondensator (trench capacitor) im Substrat ausgebildet ist und unterhalb des an der Oberfläche des gemeinsamen Substrates liegenden Feldeffekttransistors (Auswahltransistor) mit isolierter Gatelektrode (Transfer-Elektrode/Wortleitung) angeordnet und mit dessen Source/Drain-Zonen elektrisch leitend verbunden ist und bei der die Source/Drain-Zonen des Feldeffekttransistors nach außen mit einer Bitleitung kontaktiert sind, wobei diese Bitleitung durch eine Isolationsschicht getrennt über der die Gateelektroden enthaltenden Ebene angeordnet ist, sowie ein Verfahren zu ihrer Herstellung.

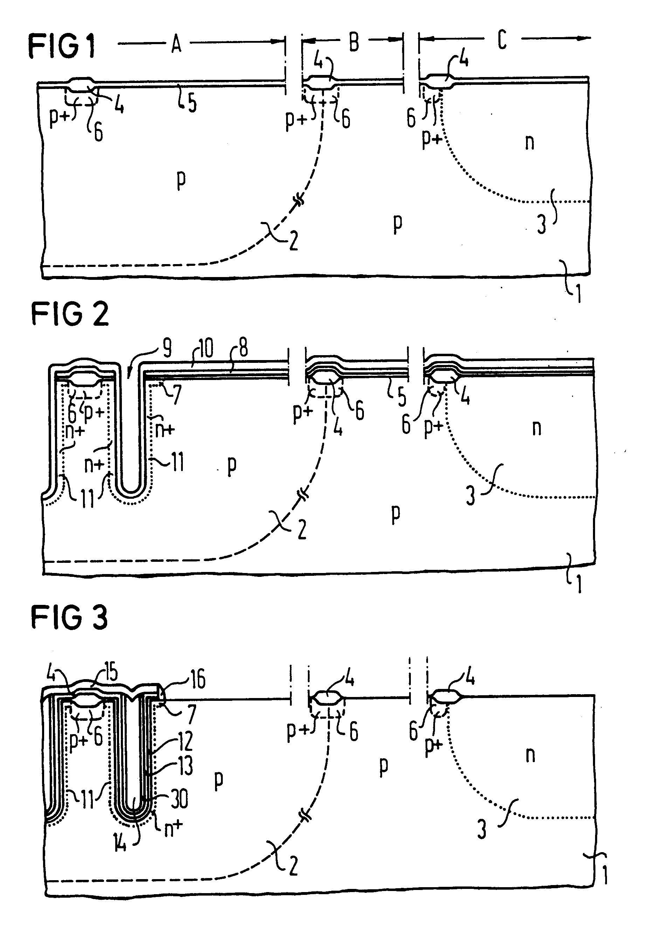

Eine solche Anordnung ist beispielsweise in dem Bericht von H. Sunami "Cell Structures for Future DRAMs" im Technical Digest IEDM 1985, Seiten 694 bis 697, in Figur 3 mit trench capacitor bezeichnet.

Weitere 1-Transistorzellen-Grabenkondensator-Anordnungen sind auch aus den europäischen Patentanmeldungen EP-A-0 149 799 (Toshiba) oder EP-A-0 108 390 (Hitachi) zu entnehmen.

Allen diesen Anordnungen ist gemeinsam, daß zur Erhöhung der Packungsdichte bei dynamischen Speichern (DRAMs) aus Gründen der kleineren, zur Verfügung stehenden Zellflächen und aufgrund der Störsicherheit erforderlichen Kapazitätsgrößen von 30 bis 50 fF der Kondensator als Grabenzelle ausgeführt ist.

Durch Nutzung der dritten Dimension in der Grabenzelle ist die Möglichkeit gegeben, bei minimalem Platzbedarf eine Zellkapazität von 40 fF zu realisieren. Dabei ist die Grabentiefe oft bis zu 10 $\mu$m tief, was technisch schwierig beherrschbar ist.

Der Erfindung liegt deshalb die Aufgabe zugrunde, unter Verwendung der dreidimensionalen Integration der Bauelemente eine 1-Transistorzellenanordnung mit beherrschbarer Grabentiefe für dynamische Halbleiterspeicher anzugeben, bei der neben einer Optimierung der elektrischen Parameter, unter anderem bezüglich Unempfindlichkeit gegenüber Herstelltoleranzen, sowie der Minimierung von Degradationseffekten im Langzeitbetrieb, eine weitere Reduzierung der Speicher-Zellfläche möglich ist. Eine weitere Aufgabe der Erfindung ist es, durch ein einfaches Verfahren diese Transistorzellenanordnung herzustellen.

Zur Lösung der erfindungsgemäßen Aufgabe wird eine dreidimensionale 1-Transistorzellenanordnung der eingangs genannten Art vorgeschlagen, die dadurch gekennzeichnet ist, daß

a) der Bitleitungskontakt zum Anschluß des Auswahltransistors selbstjustiert auf dem im Halbleitersubstrat liegenden Draingebiet ausgeführt ist, und daß der Bitleitungskontakt die allseitig mit Isolierschichten bedeckte Gateelektrode sowie den zur lateralen Isolation der einzelnen Elemente der Schaltungen vorgesehenen benachbarten Feldoxidbereich überlappt,

b) die unter der Bitleitung und über der Gateebene liegende Isolationsschicht aus mindestens einer Doppelschicht aus Siliziumoxid und Siliziumnitrid besteht, wobei die an die Bitleitung angrenzende Schicht eine Siliziumoxidschicht ist.

Es liegt im Rahmen der Erfindung, daß die unter der Bitleitung liegende Isolationsschicht eine Dreifachschicht aus Siliziumoxid/Siliziumnitrid/Siliziumoxid ist, wobei die Siliziumnitridschicht wesentlich dünner als die Schichtdicke der darüberliegenden Siliziumoxidschicht ist, aber mindestens 10 nm beträgt und daß die Gateelektrode aus Polysilizium besteht und allseitig von einer Siliziumoxidschicht eingekapselt ist wobei die Schichtdicke an den Seitenflanken im Bereich von 200 nm liegt. Gemäß einem Ausführungsbeispiel nach der Lehre der Erfindung beträgt die Grabenkondensatortiefe 4 $\mu$m und der Querschnitt 0,8 bis 1 $\mu$m$^2$. Die Bitleitung besteht aus einer Doppelschicht aus vorzugsweise mit Arsen oder Phosphor dotiertem polykristallinem Silizium und Tantal- bzw. Molybdänsilizid.

Durch die selbstjustierte Ausbildung des Kontaktes der Bitleitung zum Anschluß des Auswahltransistors wird durch die Einsparung der durch die Lithographie bedingten Lageungenauigkeit der Platzbedarf einer Speicherzelle mit 0,9 $\mu$m Design-Regeln von 12,2 $\mu$m$^2$ auf 10,2 $\mu$m$^2$, das heißt um fast 20 % gegenüber der konventionellen Kontaktierungstechnik, wie sie beispielsweise aus dem Bericht von Sakamoto et. al. aus dem Bericht "Buried Storage Electrode Cell for Megabit DRAMs", im Technical Digest, IEDM 1985, Seiten 710 bis 713 zu entnehmen ist, reduziert. Die Verwendung einer zusätzlichen Maske erübrigt sich. Kurzschlüsse zur Gateelektrode werden durch die Oxideinkapselung der Gateelektrode, die durch einen Oxidspacer an den Flanken der Gateelektrode bewirkt wird, unterbunden.

Ein selbstjustierter Bitleitungskontakt zum Anschluß des Auswahltransistors in einer Halbleiterspeicherzelle ist aus JP-A-6 154 661 (Toshiba) bekannt.

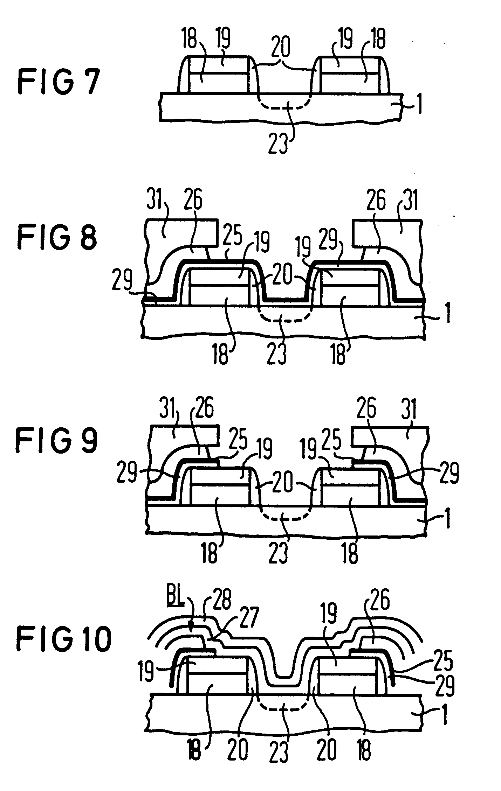

Die dielektrische Dreifachschicht unter der Bitleitung (Siliziumoxid/Siliziumnitrid/Siliziumoxid) erlaubt eine Kontaktlochätzung zur Öffnung des Drainkontaktes, welche im Kontaktloch nicht merklich das Feldoxid und die Oxidflanken der Gateelektroden angreift. Nähere Einzelheiten sind der Beschreibung zu den Figuren 7 bis 10 zu entnehmen.

Weitere Ausgestaltungen der Erfindung, insbesondere ein Verfahren zu ihrer Realisierung, ergeben sich aus den Unteransprüchen.

Im folgenden wird anhand eines Ausführungsbeispiels und der Figuren 1 bis 12 die Erfindung noch näher beschrieben. Dabei zeigen:

die Figuren 1 bis 6

im Schnittbild den Aufbau eines 4-Megabit-DRAMs, bei dem aufbauend auf einem CMOS-Prozeß mit sub-$\mu$m-Design-Regeln eine 3D-Speicherzelle in Dreilagen-Polysilizium-Technik mit einem selbstjustierenden, direkten Kontakt nach der Erfindung beschrieben wird,

die Figuren 7 bis 10

im Schnittbild die erfindungswesentlichen Verfahrensschritte a) der Oxideinkapselung des Transfer-Gates durch einen Oxidspacer an einer Doppelschicht Polysilizium/Oxid und b) der Direkt-Kontakt-Ätzung durch ein Siliziumoxid/Siliziumnitrid/Siliziumoxid-Dielektrikum im Detail zur Herstellung des selbstjustierten, überlappenden Bitleitungskontaktes und

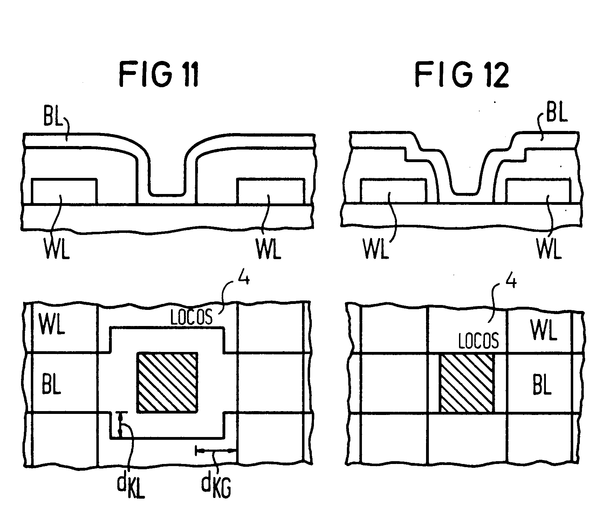

die Figuren 11 und 12

Bitleitungskontakte im Schnittbild und Layout im Vergleich: konventioneller Kontakt (Figur 11) und selbstjustierender Kontakt, überlappend zu Gate und Feldoxid nach der Erfindung (Figur 12).

Gleiche Teile sind in allen Figuren mit gleichen Bezugszeichen versehen.

Da für alle Verfahrensschritte in den Figuren 1 bis 6 alle Schritte der Speicherzellenherstellung auch für die Randelektronik, wo sowohl konventionelle wie überlappende Kontakte verwandt werden können, genutzt werden, sind Schnittbilder durch die gesamte Anordnung gezeigt, wobei der Speicherzellenbereich mit A, der Zwischenbereich mit B und der Randelektronikbereich mit C bezeichnet werden. Dabei sind in den einzelnen Figuren die wesentlichen Verfahrensschritte zusammengefaßt dargestellt.

Figur 1: In einem $p^-$-dotierten einkristallinen Siliziumsubstrat 1 (5 Ohm cm) werden zunächst in bekannter Weise p- und n-Wannen 2, 3 und Feldoxidbereiche 4 (LOCOS-Verfahren mit Nitridmaske) erzeugt. Die p-Wanne 2 ist eine Grundvoraussetzung für eine hohe Integrationsdichte, da sie die Leckströme zwischen benachbarten Grabenkondensatorzellen niedrig hält. Die n-Wanne 3 wird für die bei dem CMOS-Prozeß vorhandenen p-Kanal-Transistoren benötigt. Beide Wannen 2, 3 werden durch entsprechend tiefe Implantationen, kombiniert mit einem Hochtemperatur-Eintreibschritt, hergestellt.

Die Feldoxidation dient zur Erzeugung eines teilweise in das Siliziumsubstrat 1 versenkten thermischen Oxids 4, welches zur lateralen Isolation der einzelnen Schaltungselemente benötigt wird.

Nur in den Gebieten, die nicht durch die Siliziumnitridschicht der LOCOS-Maske geschützt waren, ist das Feldoxid 4 gewachsen. In Figur 1 ist die Nitridmaske bis auf das unter dem Nitrid liegende thermische Oxid 5 entfernt. Die mit $p^+$ bezeichneten Bereiche 6 sind durch die Feldimplantation (Bor) entstanden.

Figur 2: In die Bereiche der späteren Zellenfelder A wird eine flache Arsen-Implantation 7 (HiC = high capacity-Implantation) gesetzt, um Kapazitätsschwankungen im planaren Teil des Zellenkondensators bei unterschiedlich angelegter Spannung möglichst gering zu halten. Die übrigen Bereiche der Substratoberfläche sind dabei durch Photolack (nicht dargestellt) gegen die Implantation geschützt. Mit einer Ätzmaske 8 aus Siliziumoxid und Siliziumnitrid werden nun anisotrop (das heißt mit senkrechten Kanten) ca. 5 $\mu$m tiefe Gräben 9 in das Siliziumsubstrat 1 geätzt. Durch diese Erweiterung in die dritte Dimension kann die zur Erhaltung einer zuverlässigen Speicherfunktion notwendige Fläche der Kondensatorelektroden trotz hoher Integrationsdichte gewährleistet werden. Um auch im Graben 9 (trench), ebenso wie im planaren Bereich die Kapazität stabil zu halten, werden Boden und Wände des Grabens 9 durch Ausdiffusion von Arsen aus einer abgeschiedenen arsenhaltigen Siliziumoxidschicht 10 dotiert. Es entsteht die $n^+$-Grabendotierung 11. Der planare Bereich wird durch die Ätzmaske 8 vor einer unerwünschten Dotierung geschützt.

Figur 3: Nach naßchemischer Entfernung des Arsenosilikatglases 10 und Abätzen der Nitridmaske 8 wird der Graben (9) mit einem dünnen Dielektrikum 12 ausgekleidet; anschließend wird die aus Phosphor dotiertem, polykristallinem Silizium bestehende Elektrode 13 (erste Polyebene) in dem Graben (9) abgeschieden. Der Graben wird anschließend nach Aufbringen einer Siliziumoxidschicht 30 ebenfalls mit Polysilizium 14 aufgefüllt und mit einer abgeschiedenen Siliziumoxidschicht 15 elektrisch isoliert. Die seitliche Isolation der Poly (1)-Elektrode 13 kann zum Beispiel mit Hilfe der bekannten Spacer-Technik (wird später noch näher erläutert) erfolgen. Das dabei entstehende Flankenoxid ist mit 16 bezeichnet.

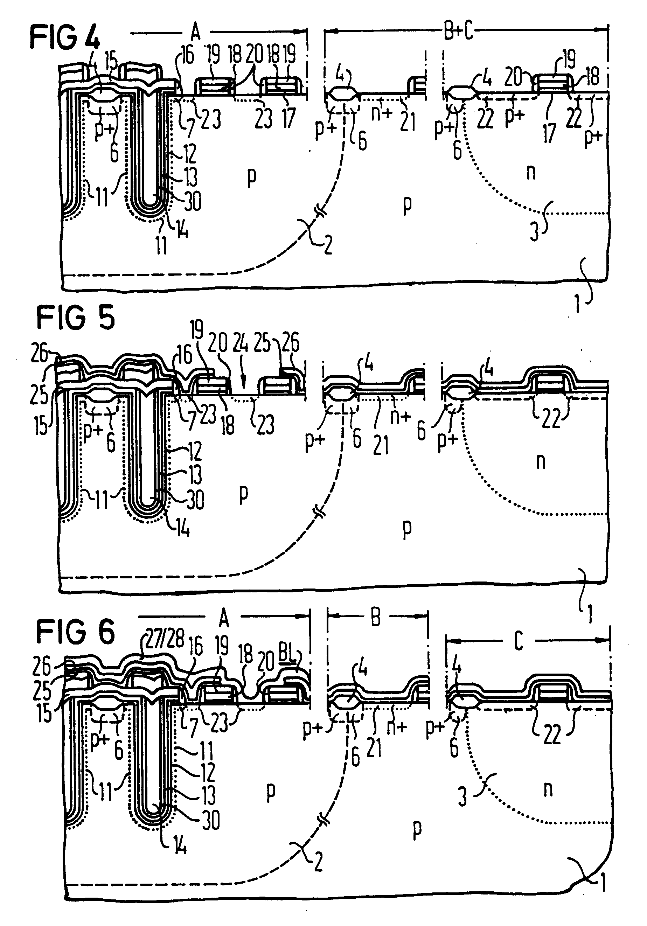

Figur 4: Nach einer thermischen Oxidation zur Erzeugung des Gateoxids 17 wird wieder eine Schicht aus polykristallinem Silizium 18 abgeschieden, mit Phosphor dotiert, mit einer Siliziumoxidschicht 19 bedeckt und die Mehrfachschicht 18, 19 anschließend strukturiert. Durch diese Schritte werden sowohl die Gates der n- und p-Kanal-Transistoren als auch leitende Verbindungen der Schaltung für kürzere Entfernungen hergestellt. Nach einer seitlichen Isolierung der polykristallinen Siliziumstrukturen 18 (zweite Poly-Ebene) durch die bekannte Oxidspacer-Technik (Abscheiden von Siliziumoxid durch thermische Zersetzung von Tetraethylorthosilikat und Rückätzen, so daß nur die seitlichen Flankenoxide 20 stehenbleiben) werden die $n^+$- und $p^+$-Ionenimplantationen 21, 22, 23 durchgeführt und so die Source/Drain-Zonen der n- bzw. p-Kanal-Transistoren in bekannter Weise gebildet.

Figur 5 zeigt die Anordnung nach der erfindungsgemäßen Ätzung des selbstjustierten direkten Kontaktes (24) für die Bitleitung BL.

Eine weitere Voraussetzung zur Realisierung der hohen Integrationsdichte im Zellenfeld A ist der Kontakt 24 zwischen der dritten Polysiliziumebene (Bitleitung BL) und dem $n^+$-Diffusionsgebiet 23, der durch die Erfindung ohne großen Sicherheitsabstand zwischen Kontaktloch 24 und Gate 18 sowie zwischen Kontaktloch 24 und Feldoxidkante 4 hergestellt werden kann.

Durch eine spezielle Prozeßfolge, die anhand der Figuren 7 bis 10 noch näher beschrieben wird und auf der selektiven Ätzung einer Dreifachschicht Siliziumoxid (nicht dargestellt)/Siliziumnitrid 25/Siliziumoxid 26 beruht, ist dieser Kontakt 24 selbstjustierend und erfüllt damit die gestellten Anforderungen der hohen Integration.

Figur 6 zeigt die Anordnung mit Bitleitung BL, wobei zur Herstellung einer niederohmigen Verdrahtungsebene diese aus einer Kombination von arsendotiertem polykristallinem Silizium 27 und Tantal- oder Molybdänsilizid 28 ($MoSi_x$) aufgebracht und strukturiert wird.

Durch die Arsendotierung werden flache Diffusionen erhalten, ohne daß die schwach dotierten Drainzonen der LDD-Transistoren (= lightly doped drain) durch den angrenzenden selbstjustierten Bitleitungskontakt beeinflußt werden. Der Kontaktwiderstand kann weiter dadurch reduziert werden, daß ein Teil der Arsen-Ionen in die Grenzfläche zwischen polykristallinem Silizium und der $n^+$-diffundierten Zone 23 durch Ionenimplantation eingebracht wird, so daß das dünne natürlich gewachsene Oxid an dieser Grenzfläche aufgebrochen wird.

Zur Isolation zwischen Bitleitung BL und Aluminiumebene (nicht dargestellt) wird ein Bor-Phosphor-Silikatglas verwendet und zur Planarisierung einem Verfließprozeß unterworfen. Dieser und alle weiteren Verfahrensschritte der Kontaktlochätzung, der Metallisierung (Herstellung der Wortleitungen) und Passivierung des Bausteins erfolgen in bekannter Weise und sind nicht mehr dargestellt.

Figur 7: Die Prozeßschritte für den voll überlappenden Bitleitungskontakt BL beginnen mit der Oxideinkapselung der Gates. Figur 7 zeigt im Schnittbild (Ausschnitt aus Figur 4 Zellenfeld A, rechte Seite) den Bereich des Siliziumsubstrates 1, auf dem die mit der Siliziumoxidschicht 19 strukturierten Gateelektroden 18 mit dem Flankenoxid 20 versehen worden sind. Dazu wird das Siliziumoxid durch thermische Zersetzung von Tetraethylorthosilikat ganzflächig aufgebracht und die Schicht so zurückgeätzt, daß nur an den Gatestrukturkanten das Spaceroxid 20 stehenbleibt. Die Schichtdicke am Spacerfuß wird dabei auf ca. 200 nm eingestellt. Da bei der Spacerätzung die Oxidkante über Polysilizium verrundet werden, ist die Dicke des Spaceroxids 20 in der Höhe der oberen Polysiliziumkante leicht geringer als am Spacerfuß.

Figur 8: Das Dielektrikum zwischen der Poly-2-Ebene (Gateebene) und der Poly-3-Ebene, mit der die Bitleitungen BL des Zellenfeldes strukturiert werden, besteht - neben der Oxideinkapselung 19, 20 der Gates - aus der Schichtenfolge: 80 nm Siliziumoxid 29/ 20 nm Siliziumnitrid 25/200 nm Siliziumoxid 26, wobei die Siliziumoxidschichten 26 und 29 wieder durch thermische Zersetzung von Tetraethylorthosilikat erzeugt sind. Diese Dreifachschicht 25, 26, 29 muß bei der Direkt-Kontaktätzung 24 für den Bitleitungskontakt auf der diffundierten Zone 23 durchgeätzt werden. Dies geschieht zum Beispiel auf folgendem Wege:
Zunächst wird eine Photolackmaske 31 erzeugt und die Oxidschicht 26 naßchemisch mit einem Ätzgemisch aus 7 Teilen Ammonfluorid ($NH_4F$) und einem Teil Flußsäure (HF) in 60 Sekunden bei sehr guter Selektivität zum Siliziumnitrid 25 geätzt. Die Siliziumnitridschicht 25 wird dabei nicht angegriffen; sie dient vielmehr als Ätzstop.

Figur 9: Anschließend erfolgt die Ätzung der Doppelschicht Siliziumnitrid 25/Siliziumoxid 29 durch einen Trockenätzprozeß, maßhaltig zur Lackkante 31. Die Ätzung geschieht im Trifluormethan/Sauerstoffplasma ($CHF_3/O_2$ = 75/5 sccm, 1350 Watt, 50 mT). Geätzt wird nach Zeit. Zur Sicherstellung eines guten Kontaktwiderstandes Bitleitung BL zu Diffusionsgebiet 23 empfiehlt es sich, die Ätzung leicht zu überziehen (mindestens um 15 nm Oxid). Dabei wird die Oxidisolation 19 des Gates etwas gedünnt. Trotzdem kann eine verbleibende Oxiddicke 19 auf dem Polysiliziumgate 18 von überall größer 100 nm gewährleistet werden. Durch die gute Selektivität Oxid zu Silizium (20 : 1) besteht keine Gefahr der Substratanätzung. Im Kontaktloch wird das Feldoxid höchstens um 50 nm gedünnt; die Diodeneigenschaften werden dadurch nicht beeinflußt. Wie aus der Figur 9 zu entnehmen ist, wird durch die Naßätzung ein Kontaktloch mit abgeschrägten Wänden erzeugt.

Figur 10 zeigt die Anordnung nach dem Aufbringen der aus, mit Arsen implantiertem Polysilizium 27 und gesputtertem Tantalsilizid oder Molybdänsilizid 28 bestehenden Bitleitung BL. Der Kontaktbereich der Polysiliziumschicht 27 zur Diffusionszone 23 wird definiert durch die Kanten des Feldoxids (nicht dargestellt) und den Oxidspacer 20 am Gate. Der Abstand Kontakt zum Gate beträgt nur 200 nm.

Figur 11 zeigt einen nach konventionellen Verfahren hergestellten Bitleitungskontakt.

Im konventionellen Design eines Transistors hängen die Designabstände des Kontaktlochs auf Source/Drain zu Gate ($d_{KG}$) bzw. zu Feldoxid ($d_{KL}$) von der Justiergenauigkeit der entsprechenden Phototechniken zueinander und von der Maßhaltigkeit der Strukturübertragung ab. Mit WL ist die Wortleitung aus polykristallinem Silizium, mit BL die Bitleitung aus der Doppelschicht polykristallines Silizium/Metallsilizid bezeichnet. LOCOS bezeichnet die Feldoxidkante; der schraffierte Bereich umfaßt den Kontakt.

Figur 12: Für eine Technologie, die im Design den Überlapp des Source/Drain-Kontaktes über Gate und Feldoxid (LOCOS) - bei sicherer Isolation - ermöglicht, wie es durch die Erfindung der Fall ist, werden $d_{KG}$ und $d_{KL}$ unabhängig von der Phototechnik. Man spricht auch von selbstjustierenden Kontakten. Diese ermöglichen eine wesentliche Steigerung der Integrationsdichte der Bauelemente, wie aus der Figur 12 zu entnehmen ist.

Der Abstand $d_{KG}$ Kontakt zu Gate beträgt 0,2 $\mu$m (= Spacerbreite); der Abstand $d_{KL}$ Kontakt zu Feldoxidbereich (LOCOS) beträgt 0 $\mu$m.

Die elektrischen Parameter des Bausteins, wie zum Beispiel Isolation Wort- zu Bitleitung, Bitleitung zu Substrat (pn-Übergang), Transistoreigenschaften/Degradation, Leckströme des Bausteins, werden durch den platzsparenden Bitleitungskontakt nicht in ungünstiger Weise beeinflußt.

## Patentansprüche

1. Dreidimensionale 1-Transistorzellenanordnung für dynamische Halbleiterspeicher, bei der der Kondensator für die zu speichernden Ladungen als Grabenkondensator (9) (trench-capacitor) im Substrat (1) ausgebildet ist und unterhalb des an der Oberfläche des gemeinsamen Substrates (1) liegenden Feldeffekttransistors (Auswahltransistor) mit isolierter Gateelektrode (Transfer-Elektrode/Wortleitung) angeordnet ist und mit dessen Source/Drain-Zonen (23) elektrisch leitend verbunden ist und bei der die Source/Drain-Zonen (23) des Feldeffekttransistors nach außen mit einer Bitleitung (BL) kontaktiert sind, wobei diese Bitleitung (BL) durch eine Isolationsschicht (25, 26, 29) getrennt über der die Gateelektroden (18) enthaltenden Ebene angeordnet ist, **dadurch gekennzeichnet, daß**

a) der Bitleitungskontakt (24) zum Anschluß des Auswahltransistors selbstjustiert auf dem im Halbleitersubstrat (1) liegenden Draingebiet (23) ausgeführt ist, und daß der Bitleitungskontakt die allseitig mit Isolierschichten (19, 20) bedeckte Gateelektrode (18) sowie den zur lateralen Isolation der einzelnen Elemente der Schaltung vorgesehenen benachbarten Feldoxidbereich (4) überlappt,

b) die unter der Bitleitung (BL) und über der Gateebene liegende Isolationsschicht aus mindestens einer Doppelschicht aus Siliziumoxid (26) und Siliziumnitrid (25) besteht, wobei die an die Bitleitung (BL) angrenzende Schicht eine Siliziumoxidschicht (26) ist.

2. Dreidimensionale 1-Transistorzellenanordnung nach Anspruch 1, **dadurch gekennzeichnet,** daß die unter der Bitleitung (BL) liegende Isolationsschicht eine Dreifachschicht aus Siliziumoxid (26)/Siliziumnitrid (25)/Siliziumoxid (29) ist, wobei die Siliziumnitridschicht (25) wesentlich dünner als die Schichtdicke der darüberliegenden Siliziumoxidschicht (26) ist, aber mindestens 10 nm beträgt.

3. Dreidimensionale 1-Transistorzellenanordnung nach Anspruch 1 oder 2, **dadurch gekennzeichnet,** daß die Gateelektrode (18) aus Polysilizium besteht und allseitig von einer Siliziumoxidschicht (19, 20) eingekapselt ist und daß die OxidSchichtdicke an den Seitenflanken (20) im Bereich von 200 nm liegt.

4. Dreidimensionale 1-Transistorzellenanordnung nach einem der Ansprüche 1 bis 3, **dadurch gekennzeichnet,** daß der Auswahltransistor ein n-Kanal-MOS-Feldeffekttransistor ist, der Grabenkondensator (9) mit $n^+$-dotierten Seitenwänden (11, 13) und einer dazwischenliegenden aus einer Dreifachschicht Siliziumoxid/Siliziumnitrid/Siliziumoxid bestehenden Isolationsschicht (12) in einer p-Wanne (2) im $p^-$-dotierten Halbleitersubstrat (1) angeordnet ist und der Graben (9) mit undotiertem Polysilizium (14) aufgefüllt ist.

5. Dreidimensionale 1-Transistorzellenanordnung nach einem der Ansprüche 1 bis 4, **dadurch gekennzeichnet,** daß daß die Grabenkondensatortiefe 4 $\mu$m und der Querschnitt 0,8 bis 1,0 $\mu$m$^2$ beträgt.

6. Dreidimensionale 1-Transistorzellenanordnung nach einem der Ansprüche 1 bis 5, **dadurch gekennzeichnet,** daß die Bitleitung (BL) aus einer Doppelschicht aus $n^+$-dotiertem Polysilizium (27) und einem Silizid eines hochschmelzenden Metalles, vorzugsweise aus Tantalsilizid (28) oder Molybdänsilizid besteht.

7. Dreidimensionale 1-Transistorzellenanordnung nach Anspruch 6, **dadurch gekennzeichnet,** daß die Polysiliziumschicht (27) mit Arsen und/oder Phosphor dotiert ist.

8. Dreidimensionale 1-Transistorzellenanordnung nach einem der Ansprüche 1 bis 7, **dadurch gekennzeichnet,** daß die Siliziumnitridschicht (25) eine Schichtdicke im Bereich von 10 - 50 nm aufweist.

9. Verfahren zum Herstellen des Bitleitungskontaktes (24) zum Anschluß des Auswahltransistors einer 1-Transistorzellenanordnung für dynamische Halbleiterspeicher, bei der der Kondensator für die zu speichernden Ladungen als Grabenkondensator (9) (trench capacitor) im Substrat (1) ausgebildet ist und unterhalb des an der Oberfläche des gemeinsamen Substrates (1) liegenden Feldeffekttransistors (Auswahltransistor) mit isolierter Gateelektrode (Transfer-Elektrode/Wortleitung) angeordnet ist nach einem der Ansprüche 1 bis 8, wobei

a) nach dem Ablauf der folgenden Verfahrensschritte:

$a_1$) Herstellen der für die laterale Isolation der einzelnen Elemente der Schaltung erforderlichen Feldoxidbereiche (4) durch lokale Oxidation (bekanntes LOCOS-Verfahren),

$a_2$) Erzeugen des Grabenkondensators (9, 11, 12, 13) in der p-Wanne (2) eines $p^-$ dotierten Substrats (1),

$a_3$) Auffüllen des Grabens (9) mit undotiertem polykristallinem Silizium (14),

$a_4$) elektrische Isolation des Grabens (9, 11, 12, 13, 14) durch eine abgeschiedene Siliziumoxidschicht (15, 16) und

$a_5$) Herstellung des Gateoxids (17) durch thermische Oxidation,

b) ganzflächig eine n-dotierte polykristalline Siliziumschicht (18) abgeschieden wird,

c) ganzflächig eine Siliziumoxidschicht (19) aufgebracht wird,

d) die Doppelschicht (18, 19) polykristallines Silizium/Siliziumoxid entsprechend der Gateelektrode der n- und p-Kanal-Transistoren der Schaltung, als auch zusätzlich leitender Verbindungen der Schaltung mit Phototechnik strukturiert wird,

e) durch Abscheidung aus der Gasphase eine weitere Siliziumoxidschicht abgeschieden wird und anschließend bis auf die an den Polysiliziumstrukturen befindlichen Flankenoxide (20) (sogenannte Spacer-Technik) wieder entfernt wird,

f) die Source/Drain-Zonen (21, 22, 23) der n- und p-Kanal-Transistoren durch Ionenimplantation gebildet werden,

g) ganzflächig eine dielektrische Dreifachschicht (29, 25, 26) bestehend aus Siliziumoxid, Siliziumnitrid und Siliziumoxid aufgebracht wird,

h) nach Durchführung einer Photolacktechnik (31) der Bereich (24) des Kontaktes zur diffundierten Drainzone (23) des Auswahltransistors auf der dielektrischen Dreifachschicht (29, 25, 26) festgelegt wird,

i) die Ätzung zur Öffnung des Kontaktes (24) in mindestens zwei Schritten durchgeführt wird, wobei

$i_1$) zunächst die Siliziumoxidschicht (26) mit guter Selektivität zur darunterliegenden Siliziumnitridschicht (25) isotrop geätzt wird und

$i_2$) unter Verwendung der Photolackmaskenkante (31) die Nitridschicht (25) mit der draunterliegenden Siliziumoxidschicht (29) anisotrop geätzt wird, bis die zur Kontaktierung vorgesehene Oberfläche des Substrates (1) freigelegt ist,

j) die die Bitleitung (BL) bildende Doppelschicht (27, 28) aus n-dotiertem polykristallinem Silizium (27) und Tantal- bzw. Molybdänsilizid (28) abgeschieden und entsprechend strukturiert wird und

k) die Abscheidung des zur Isolation der Bitleitung (BL) und der äußeren Metallisierungsebene vorgesehene Zwischenoxidschicht, die Kontaktlochätzung für die äußeren Anschlüsse (auch Wortleitung WL) und die Herstellung der Metallisierung sowie die Passivierung der Anordnung in bekannter Weise vorgenommen wird.

10. Verfahren nach Anspruch 9, **dadurch gekennzeichnet,** daß der erste Ätzschritt naßchemisch und der zweite Ätzschritt durch reaktives Ionenätzen (Trockenätzen) durchgeführt wird.

11. Verfahren nach Anspruch 9 oder 10, **dadurch gekennzeichnet,** daß die Naßätzung der Siliziumoxidschicht (26) in 7 Teilen Ammonfluorid und 1 Teil Flußsäure mit einer Zeitdauer im Bereich von 60 Sekunden bei einer Schichtdicke der Siliziumoxidschicht von 200 nm und der Trockenätzprozeß in einem Trifluormethan/Sauerstoff-Gemisch durchgeführt wird.

12. Verfahren nach einem der Ansprüche 9 bis 11, **dadurch gekennzeichnet,** daß die Schichtdicke der als Ätzstop dienenden Siliziumnitridschicht (25) auf 10 - 50 nm eingestellt wird.

**13.** Verfahren nach Anspruch 9, **dadurch gekennzeichnet,** daß die Ätzung nach Verfahrensschritt i) in drei Schritten durch reaktives Ionenätzen erfolgt, wobei der erste Ätzschritt im Trifluormethan-Plasma, der zweite Ätzschritt im Schwefelhexafluorid-Plasma und der dritte Ätzschritt in Trifluormethan/Sauerstoff-Plasma durchgeführt wird.

**14.** Verfahren nach einem der Ansprüche 9 bis 13, **dadurch gekennzeichnet,** daß die Siliziumoxidschicht (16, 20) zur Flankenisolation sowie die, die Siliziumnitridschicht bedeckende Silizi-umoxidschicht (26) durch thermische Zerset-zung von Tetraethylorthosilikat gebildet wird.

**15.** Verfahren nach einem der Ansprüche 9 bis 14, **dadurch gekennzeichnet,** daß die Schichtdicke der für die Flankenisolation vorgesehenen Siliziumoxidschicht (20) als auch die Schichtdicke der auf der Siliziumnitridschicht (25) befindlichen Siliziumoxidschicht (26) auf ca. 200 nm eingestellt wird.

## Claims

**1.** Three-dimensional 1-transistor cell arrangement for dynamic semiconductor memories, in which the capacitor for the charges to be stored is constructed as a trench capacitor (9) in the substrate (1) and is arranged underneath the field-effect transistor (selection transistor), located on the surface of the common substrate (1), with an insulated gate electrode (transfer electrode/word line) and is electrically conductively connected to the source/drain zones (23) of said field-effect transistor, and in which the source/drain zones (23) of the field-effect transistor are made contact with on the exterior by a bit line (BL), this bit line (BL) being arranged above the plane containing the gate electrodes (18) and being isolated by means of an insulating layer (25, 26, 29), characterised in that

a) the bit line contact (24) for connection of the selection transistor is configured in a self-adjusting manner on the drain region (23) located in the semiconductor substrate (1), and in that the bit line contact overlaps the gate electrode (18), which is covered on all sides with insulating layers (19, 20), and the adjacent field-oxide region (4), which is provided for lateral insulation of the individual elements of the circuit,

b) the insulation layer located under the bit line (BL) and above the gate plane consists of at least one double layer of silicon oxide (26) and silicon nitride (25), the layer adjacent to the bit line (BL) being a silicon-oxide layer (26).

**2.** Three-dimensional 1-transistor cell arrangement according to Claim 1, characterised in that the insulation layer located under the bit line (BL) is a triple layer of silicon oxide (26)-/silicon nitride (25)/silicon oxide (29), the silicon-nitride layer (25) being substantially thinner than the layer thickness of the siliconoxide layer (26) located above it, but being at least 10 nm.

**3.** Three-dimensional 1-transistor cell arrangement according to Claim 1 or 2, characterised in that the gate electrode (18) consists of polysilicon and is encapsulated on all sides by a silicon-oxide layer (19, 20), and in that the oxide layer thickness on the side flanks (20) is in the region of 200 nm.

**4.** Three-dimensional 1-transistor cell arrangement according to one of Claims 1 to 3, characterised in that the selection transistor is an n-channel MOS field-effect transistor, the trench capacitor (9) with $n^+$-doped side walls (11, 13) and an insulation layer (12), which is located between them and consists of a triple layer of silicon oxide/silicon nitride/silicon oxide, being arranged in a p-trough (2) in the $p^-$-doped semiconductor substrate (1), and the trench (9) being filled with undoped polysilicon (14).

**5.** Three-dimensional 1-transistor cell arrangement according to one of Claims 1 to 4, characterised in that the trench capacitor depth is 4 $\mu$m and the cross-section is 0.8 to 1.0 $\mu$m$^2$.

**6.** Three-dimensional 1-transistor cell arrangement according to one of Claims 1 to 5, characterised in that the bit line (BL) consists of a double layer of $n^+$-doped polysilicon (27) and a silicide of a high-melting-point metal, preferably of tantalum silicide (28) or molybdenum silicide.

**7.** Three-dimensional 1-transistor cell arrangement according to Claim 6, characterised in that the polysilicon layer (27) is doped with arsenic and/or phosphorus.

**8.** Three-dimensional 1-transistor cell arrangement according to one of Claims 1 to 7, characterised in that the silicon-nitride layer (25) has a layer thickness in the region of 10 to 50 nm.

**9.** Method for producing the bit line contact (24) for connection of the selection transistor of a 1-transistor cell arrangement for dynamic semiconductor memories, in which the capacitor for the charges to be stored is constructed as a trench capacitor (9) in the substrate (1) and is arranged underneath the field-effect transistor (selection transistor), located on the surface of the common substrate (1), with an insulated gate electrode (transfer electrode/word line), according to one of Claims 1 to 8,

a) after the following method steps have been carried out:

a$_1$) preparation of the field-oxide regions (4) required for lateral insulation of the individual elements of the circuit by local oxidation (known LOCOS method),

a$_2$) production of the trench capacitor (9, 11, 12, 13) in the p-trough (2) of a p$^-$-doped substrate (1),

a$_3$) filling of the trench (9) with undoped polycrystalline silicon (14),

a$_4$) electrical insulation of the trench (9, 11, 12, 13, 14) by a deposited silicon-oxide layer (15, 16) and

a$_5$) production of the gate oxide (17) by thermal oxidation,

b) an n-doped polycrystalline silicon layer (18) being deposited over the complete area,

c) a silicon-oxide layer (19) being applied over the complete area,

d) the double layer (18, 19) of polycrystalline silicon/silicon oxide being structured corresponding to the gate electrode of the n- and p-channel transistors of the circuit and additionally conductive connections of the circuit, using a photographic technique,

e) a further silicon-oxide layer being deposited by deposition from the gas phase, and subsequently being removed again except for the edge oxides (20) located on the polysilicon structures (so-called spacer technique),

f) the source/drain zones (21, 22, 23) of the n- and p-channel transistors being formed by ion implantation,

g) a dielectric triple layer (29, 25, 26), consisting of silicon oxide, silicon nitride and silicon oxide, being applied over the complete area,

h) after carrying out a photoresist technique (31), the region (24) of the contact to the diffused drain zone (23) of the selection transistor being fixed on the dielectric triple layer (29, 25, 26),

i) the etching for opening the contact (24) being carried out in at least two steps,

i$_1$) the silicon-oxide layer (26) being etched isotropically, first of all, with good selectivity with respect to the silicon-nitride layer (25) located beneath it and

i$_2$) using the photoresist mask edge (31), the nitride layer (25) with the silicon-oxide layer (29) located beneath it being anisotropically etched until the surface of the substrate (1) provided for making contact is exposed,

j) the double layer (27, 28), forming the bit line (BL), being deposited from n-doped polycrystalline silicon (27) and tantalum or molybdenum silicide (28), and being appropriately structured, and

k) the deposition of the intermediate oxide layer, provided for insulation of the bit line (BL) and of the outer metallisation plane, the contact hole etching for the outer connections (including the word line WL) and the production of the metallisation as well as the passivation of the arrangement being carried out in a known manner.

**10.** Method according to Claim 9, characterised in that the first etching step is carried out in a wet-chemical manner and the second etching step is carried out by reactive ion etching (dry etching).

**11.** Method according to Claim 9 or 10, characterised in that the wet etching of the silicon-oxide layer (26) is carried out in 7 parts of ammonium fluoride and 1 part of hydrofluoric acid with a time duration in the region of 60 seconds for a layer thickness of the silicon-oxide layer of 200 nm, and the dry etching process is carried out in a trifluoromethane/oxygen mixture.

**12.** Method according to one of Claims 9 to 11, characterised in that the layer thickness of the siliconnitride layer (25) which is used as the etching stop is set to 10 - 50 nm.

**13.** Method according to Claim 9, characterised in that the etching according to method step i) is carried out in three steps by reactive ion etching, the first etching step being carried out in the trifluoromethane plasma, the second etching step in the sulphur hexafluoride plasma and the third etching step in the trifluoromethane/oxygen plasma.

**14.** Method according to one of Claims 9 to 13, characterised in that the silicon-oxide layer (16, 20) for flank insulation and the silicon-oxide layer (26) covering the silicon-nitride layer are formed by thermal decomposition of tetraethyl orthosilicate.

**15.** Method according to one of Claims 9 to 14, characterised in that the layer thickness of the silicon-oxide layer (20) provided for the flank insulation and the layer thickness of the silicon-oxide layer (26) located on the silicon-nitride layer (25) are set to approximately 200 nm.

**Revendications**

**1.** Dispositif tridimensionnel de cellule à 1 transistor pour des mémoires à semiconducteurs dynamiques, dans lequel le condensateur pour les charges devant être stockées est agencé sous la forme d'un condensateur en sillon (9) (trench-capacitor) dans le substrat (1) et est disposé au-dessous du transistor à effet de champ (transistor de sélection), disposé à la surface du substrat commun (1) et comportant une électrode de grille isolée (électrode de transfert/ligne de transmission de mots) et dont les zones de source/drain (23) sont raccordées d'une manière électriquement conductrice et dans lequel un contact extérieur est établi entre les zones de source/drain (23) du transistor à effet de champ et une ligne de transmission de bits (BL), cette ligne de transmission de bits (BL) étant disposée au-dessus du plan contenant les électrodes de grille (18), en en étant séparée par une couche isolante (25,26,29), caractérisé par le fait que

    a) le contact de la ligne de transmission de bits prévue pour le raccordement du transistor de sélection est réalisé avec auto-alignemnt sur la zone de drain (23) située dans le substrat semiconducteur (1), et que le contact de la ligne de transmission de bits chevauche l'électrode de grille (18), qui est recouverte de tous côtés par les couches isolantes (19,20), ainsi que la zone d'oxyde de champ voisine (4) prévue pour réaliser l'isolation latérale des différents éléments du circuit, et

    b) que la couche isolante située au-dessous de la ligne de transmission de bits (BL) et au-dessus du plan des grilles est constituée par au moins une couche double formée d'oxyde de silicium (26) et de nitrure de silicium (25), la couche jouxtant la ligne de transmission de bits (BL) étant une couche d'oxyde de silicium (26).

**2.** Dispositif tridimensionnel de cellule à 1 transistor suivant la revendication 1, caractérisé par le fait que la couche isolante située au-dessous de la ligne de transmission de bits (BL) est une couche triple formée d'oxyde de silicium (26)/nitrure de silicium (25)/oxyde de silicium (29), la couche de nitrure de silicium (25) ayant une épaisseur nettement plus faible que celle de la couche d'oxyde de silicium supérieure (26), tout en étant égale au moins à 10 nm.

**3.** Dispositif tridimensionnel de cellule à 1 transistor suivant la revendication 1 ou 2, caractérisé par le fait que l'électrode de grille (18) est formée de polysilicium et est encapsulée de tous côtés par une couche d'oxyde de silicium (19,20), et que l'épaisseur de la couche d'oxyde au niveau des flancs latéraux (20) est de l'ordre de 200 nm.

**4.** Dispositif tridimensionnel de cellule à 1 transistor suivant l'une des revendications 1 à 3, caractérisé par le fait que le transistor est un transistor à effet de champ MOS à canal n, que le condensateur en sillon (9) comportant des parois latérales (11,13) dopées de type $n^+$ et une couche isolante intercalaire (12) constituée par une couche triple oxyde de silicium/nitrure de silicium/oxyde de silicium, est disposée dans une cuvette (2) de type p dans le substrat semiconducteur (1) dopé de type $p^-$ et que le sillon (9) est rempli avec du polysilicium non dopé (14).

**5.** Dispositif tridimensionnel de cellule à 1 transistor suivant l'une des revendications 1 à 4, caractérisé par le fait que la profondeur du condensateur en sillon est égale à 4 $\mu$m et que la section transversale est comprise entre 0,8 et 1,0 $\mu m^2$

**6.** Dispositif tridimensionnel de cellule à 1 transistor suivant l'une des revendications 1 à 5, caractérisé par le fait que la ligne de transmission de bits (BL) est formée par une couche double formée de polysilicium (27) dopé de type $n^+$ et d'un siliciure d'un métal à point de fusion élevé, de préférence du siliciure de tantale (28) ou du siliciure de molybdène.

**7.** Dispositif tridimensionnel de cellule à 1 transistor suivant la revendication 6, caractérisé par le fait que la couche de polysilicium (27) est dopée par de l'arsenic et/ou du phosphore.

**8.** Dispositif tridimensionnel de cellule à 1 transistor suivant l'une des revendications 1 à 7, caractérisé par le fait que la couche de nitrure de silicium (25) possède une épaisseur de couche comprise dans la plage de 10-50 nm.

**9.** Procédé pour fabriquer le contact de la ligne de transmission de bits pour le raccordement du transistor de sélection d'un dispositif de cellule à 1 transistors pour des mémoires à semiconducteurs dynamiques, selon lequel le condensateur est réalisé, pour les charges devant être stockées, sous la forme d'un condensateur en sillon (9) (trench-capacitor) dans le substrat (1) et est disposé au-dessous du transistor à effet de champ (transistor de Sélection), situé sur la surface du substrat commun (1) et comportant une électrode de grille isolée (électrode de transfert/ligne de transmission de mots) selon l'une des revendications 1 à 8, et selon lequel

a) après l'exécution des étapes opératoires suivantes :

$a_1$) fabrication des zones d'oxyde de champ (4), nécessaires pour l'isolation latérale des différents éléments du circuit, par oxydation locale (procédé LO-COS connu),

$a_2$) production du condensateur en sillon (9,11,12,13) dans la cuvette (2) de type p d'un substrat (1) de type $p^-$,

$a_3$) remplissage du sillon (9) avec du silicium polycristallin non dopé (14),

$a_4$) isolation électrique du sillon (9,11,12,13,14) au moyen d'une couche d'oxyde de silicium (15,16) déposée, et

$a_5$) fabrication de l'oxyde de grille (17) par oxydation thermique,

b) on dépose sur toute la surface une couche de silicium polycristallin (18) dopé du type n,

c) on dépose sur toute la surface une couche d'oxyde de silicium (19),

d) on structure la couche double (18,19) formée de silicium polycristallin/oxyde de silicium, conformément à l'électrode de grille des transistors à canal n et p du circuit ainsi qu'en outre également des liaisons conductrices du circuit, en utilisant une technique photosensible,

e) on dépose une autre couche d'oxyde de silicium au moyen du dépôt à partir de la phase gazeuse et on l'élimine ensuite à nouveau en dehors des oxydes de flanc (20) situés sur les structures en polysilicium (ce qu'on appelle la technique Spacer),

f) on forme les zones de source/drain (21,22,23) des transistors à canal n et p par implantation ionique,

g) on dépose sur toute la surface une couche diélectrique triple (22,25,26) constituée par de l'oxyde de silicium, du nitrure de silicium et de l'oxyde de silicium,

h) après mise en oeuvre d'une technique (31) utilisant une laque photosensible, on fixe la zone (24) du contact de raccordement à la zone de drain diffusé (23) du transistor de sélection, sur la couche diélectrique triple (22,25,26),

i) on exécute la corrosion jusqu'à l'ouverture du contact (24), en au moins deux étapes, selon lesquelles

$i_1$) on exécute tout d'abord une corrosion isotrope de la couche d'oxyde de silicium (26) avec une bonne sélectivité vis-à-vis de la couche sous-jacente de nitrure de silicium (25), et

$i_2$) en utilisant le bord (31) du masque de photolaque, on corrode de façon anisotrope la couche de nitrure (25) ainsi que la couche d'oxyde de silicium sous-jacente (29) jusqu'à ce que la surface du substrat (1), prévue pour l'établissement du contact, soit mise à nu,

j) on dépose la couche double (27,28), qui constitue la ligne de transmission de bits (BL) et qui est formée par du silicium polycristallin (27) dopé du type n et du siliciure de tantale ou de molybdène (26) et on la structure de façon correspondante, et

k) on exécute de façon connue le dépôt de la couche d'oxyde intercalaire prévue pour l'isolation de la ligne de transmission de bits (BL) et du plan extérieur de métallisation, la formation par corrosion de trous de contact pour les raccords extérieurs (également la ligne de transmission de mots WL) et la fabrication de la métallisation ainsi que la passivation du dispositif.

**10.** Procédé suivant la revendication 9, caractérisé par le fait qu'on exécute la première étape de corrosion par voie chimique humide et la seconde étape de corrosion par corrosion ionique réactive (corrosion à sec).

**11.** Procédé suivant la revendication 9 ou 10, caractérisé par le fait que la corrosion par voie humide de la couche d'oxyde de silicium (26) est exécutée dans 7 parties de fluorure d'ammonium et 1 partie d'acide fluorhydrique pendant une durée de l'ordre de 60 secondes pour une épaisseur de la couche d'oxyde de silicium égale à 200 nm et on met en oeuvre le processus de corrosion à sec dans un mélange trifluorométhane/oxygène.

**12.** Procédé suivant l'une des revendications 9 à 11, caractérisé par le fait que l'épaisseur de la couche de nitrure de silicium (25) utilisée comme dispositif d'arrêt de la corrosion est réglée à 10-50 nm.

**13.** Procédé suivant la revendication 9, caractérisé par le fait que la corrosion effectuée lors de l'étape opératoire i) est exécutée en trois étapes par corrosion ionique réactive, la première étape de corrosion étant effectuée dans le plasma de trifluorométhane, la seconde étape de corrosion dans le plasma d'hexafluorure de soufre et la troisième étape de corrosion dans un plasma de trifluorométhane/oxygène.

**14.** Procédé suivant l'une des revendications 9 à 13, caractérisé par le fait que la couche de silicium (16,20) servant à réaliser l'isolation des flancs ainsi que la couche d'oxyde de silicium (26) qui recouvre la couche de nitrure de silicium, sont formées par dissociation thermique d'orthosilicate de tétraéthyle.

**15.** Procédé suivant l'une des revendications 9 à 14, caractérisé par le fait que l'épaisseur de la couche d'oxyde de silicium (20) prévue pour l'isolation des flancs ainsi que l'épaisseur de la couche d'oxyde de silicium (26) située sur la couche de nitrure de silicium (25) sont réglées à environ 200 nm.

FIG 1

FIG 2

FIG 3

FIG 4

FIG 5

FIG 6

EP 0 282 629 B1

FIG 7

FIG 8

FIG 9

FIG 10

# FIG 11

BL

WL          WL

4

| WL | LOCOS |  |
| BL |  |  |

$d_{KL}$          $d_{KG}$

# FIG 12

BL

WL          WL

4

|  | LOCOS | WL |
|  |  | BL |